Europäisches Patentamt

European Patent Office

Office européen des brevets

(11) Veröffentlichungsnummer : **0 062 241**
**B1**

(12) **EUROPÄISCHE PATENTSCHRIFT**

(45) Veröffentlichungstag der Patentschrift :
**13.06.84**

(21) Anmeldenummer : **82102475.9**

(22) Anmeldetag : **25.03.82**

(51) Int. Cl.³ : **H 05 K 5/00**

(54) **Bausatz für Schalt- und/oder Steuerschrank.**

(30) Priorität : **31.03.81 DE 3112718**

(43) Veröffentlichungstag der Anmeldung :
**13.10.82 Patentblatt 82/41**

(45) Bekanntmachung des Hinweises auf die Patenterteilung : **13.06.84 Patentblatt 84/24**

(84) Benannte Vertragsstaaten :
**AT BE CH FR GB LI NL SE**

(56) Entgegenhaltungen :
**FR-A- 2 300 442**
**US-A- 3 378 320**

(73) Patentinhaber : **Rittal-Werk Rudolf Loh GmbH & Co.
KG
Auf dem Stützelberg
D-6348 Herborn (DE)**

(72) Erfinder : **Loh, Friedhelm
Auf den Weiden
D-6344 Dietzhöltal-Ewersbach (DE)**

(74) Vertreter : **Vogel, Georg
Hermann-Essig-Strasse 35 Postfach 105
D-7141 Schwieberdingen (DE)**

**Beschreibung**

Die Erfindung betrifft einen Bausatz für Schalt- und/oder Steuerschränke zur Aufnahme von elektrischen Bauelementen und Baugruppen, der aus Schrankbauteilen mit horizontale Befestigungsränder aufweisenden Öffnungen, besteht.

Der Aufbau eines Schalt- und/oder Steuerschrankes zur Aufnahme von elektrischen Bauelementen und Baugruppen hängt sehr stark von der Unterbringung von Bedienungsfeldern, Tableaus und dem Zugang zu den untergebrachten Bauelementen und Baugruppen über Türen und Klappen ab. So ist es bis heute üblich, für die verschiedensten Anwendungsfälle ganz bestimmte Schaltschränke, Steuerschränke, Schaltpulte, Steuerpulte zu schaffen. Dies bedingt eine große Anzahl von verschiedenen Schränken, um für alle Anwendungsfälle die optimale Lösung bereitstellen zu können.

Ein Bausatz der eingangs erwähnten Art ist durch die US-A 3 878 320 bekannt. Die Schrankbauteile sind dabei U-förmig und plattenförmig gestaltet. Der Aufbau der verschiedensten Schalt- und/oder Steuerschränke erfordert eine Vielzahl von unterschiedlich großen Abdeckplatten, Türen und Klappen, so daß der Vorteil von wenigen Grund-Schrankbauteilen dadurch wieder verloren geht. Außerdem ist die Variationsmöglichkeit stark eingeschränkt.

Es ist daher Aufgabe der Erfindung, einen Bausatz für Schalt- und/oder Steuerschränke zur Aufnahme von elektrischen Bauelementen und Baugruppen der eingangs erwähnten Art zu schaffen, mit dem mit wenigen Schrankbauteilen die verschiedenartigsten Schalt- und/oder Steuerschränke zusammengebaut werden können, wobei der Zusammenbau einfach sein soll und der zusammengesetzte Schrank stets eine Raumeinheit bildet.

Diese Aufgabe wird nach der Erfindung dadurch gelöst, daß der Bausatz für Schalt- und/oder Steuerschränke aus folgenden Schrankbauteilen mit horizontale Befestigungsränder aufweisenden Öffnungen besteht :

a) einem Unterschrankteil, dessen offene Frontseite mittels einer oder mehreren Türen verschließbar ist und dessen Boden und Deckel gleich große, von horizontalen Befestigungsrändern umschlossene Öffnungen aufweisen,

b) einem Mittelschrankteil, das aus einem kastenartigen Anschlußteil und einem an dessen Frontseite anschließendem Pultteil gebildet ist, wobei das Anschlußteil im Querschnitt dem Querschnitt des Unterschrankteiles entspricht und im Boden und im Deckel Befestigungsränder und Öffnungen wie das Unterschrankteil aufweist und wobei eine offene, nach vorne geneigte Oberseite des Pultteiles mittels einer Klappe oder einer Tür verschließbar ist,

c) einem Oberschrankteil, das im Bodenbereich dem Querschnitt des Unterschrankteiles entspricht und im Boden Befestigungsränder und eine Öffnung wie das Unterschrankteil aufweist und dessen nach hinten geneigte, offene Frontseite mittels einer Klappe oder einer Tür verschließbar ist und

d) einem Abdeckteil, das im Querschnitt dem Querschnitt des Unterschrankteiles entspricht und zur Unterseite hin in horizontale Befestigungsränder abgewinkelt ist, die eine Öffnung wie im Unterschrankteil umschließen.

Durch diese Ausgestaltung eines Unterschrankteiles, eines Mittelschrankteiles, eines Oberschrankteiles und eines Abdeckteiles im Bereich der gleich ausgebildeten Öffnungen und Befestigungsränder ist es möglich, diese Schrankbauteile in beliebiger Reihenfolge und Anzahl so aufeinanderzusetzen und miteinander zu verbinden, daß eine geschlossene Raumeinheit entsteht, die sich über alle so miteinander verbundenen Schrankbauteile erstreckt. Durch bestimmte Schrankbauteil-Kombinationen und verschiedene Schrankbauteil-Reihenfolgen der miteinander verbundenen Schrankbauteile werden eine Vielzahl von Gestaltungsmöglichkeiten für Schalt- und/oder Steuerschränke geschaffen, deren Anzahl weit über der der Schrankbauteile des Bausatzes liegt.

Eine Art Versteifung des Bodens und des Deckels des mit Öffnungen versehenen Unterschrankteiles wird nach einer Ausgestaltung dadurch erreicht, daß die horizontalen Befestigungsränder des Unterschrankteiles im Bereich der Öffnungen in vertikale Abschlußränder übergehen, welche zum Innenraum des Unterschrankteiles hin abgebogen sind.

Um einen möglichst großen Verbindungsraum zwischen den miteinander zu verbindenden Schrankbauteilen zu schaffen, sieht eine Ausgestaltung vor, daß die Öffnungen quadratisch oder rechteckförmig ausgebildet sind und daß die Befestigungsränder unmittelbar in die vier vertikalen Seitenwände des Unterschrankteiles übergehen und gleiche Breite aufweisen.

Der Innenraum des Pultteiles eines Mittelschrankteiles wird nach einer Ausgestaltung dadurch voll in die Raumeinheit des aufgebauten Schalt- und/oder Steuerschrankes einbezogen, daß die horizontalen Befestigungsränder im Boden und Deckel des Anschlußteiles des Mittelschrankteiles an der Frontseite unmittelbar in den Boden und die Oberseite des Pultteiles übergehen.

Der Zugang zu den im Pultteil des Mittelschrankteiles untergebrachten Bauelementen, Baugruppen und dgl. wird nach einer Ausgestaltung dadurch erleichtert, daß die Klappe, die Tür oder dgl. im Bereich der Oberkante der offenen, nach vorne geneigten Oberseite des Mittelschrankteiles angelenkt ist. Anstelle der Klappe, der Tür kann auch eine Bedienungsplatte, ein Tableau oder dgl. an dem Mittelschrankteil angelenkt sein, ohne vom Baukastenprinzip des Bausatzes nach der Erfindung abzugehen. Das Mittelschrankteil mit dem Anschlußteil wird nach einer Ausgestaltung dabei dadurch vervollständigt, daß die übrigen horizontalen Befestigungsränder im Bereich der Öffnungen unmittelbar in die vertikalen Seitenwände des kastenförmigen Anschlußteiles des Mittelschrankteiles übergehen und gleiche Breite aufweisen.

Die Anschlußmöglichkeit für das Oberschrankteil an das Unterschrankteil bzw. das Mittelschrankteil wird nach einer Ausgestaltung dadurch geschaffen, daß die horizontalen Befestigungsränder im Boden des Oberschrankteiles in die vertikalen Seitenwände des nach hinten geneigte offene Frontseite des Oberschrankteiles übergehen und gleiche Breite aufweisen. Die Klappe, die Tür oder dgl. ist dabei vorzugsweise im Bereich der Unterkante der offenen, nach hinten geneigten Frontseite des Oberschrankteiles angelenkt. Auch hier kann anstelle der Klappe, der Tür oder dgl. auch eine Bedienungsplatte, ein Tableau oder dgl. verwendet werden, ohne das Baukastenprinzip des Bausatzes nach der Erfindung zu verlassen.

Ein Abdeckteil mit kleiner Bauhöhe und einfacher Verbindungsmöglichkeit wird nach einer weiteren Ausgestaltung dadurch geschaffen, daß das Abdeckteil plattenförmig ausgebildet ist und mittels eines umlaufenden, vertikal abgebogenen Übergangsabschnittes in die horizontalen Befestigungsränder übergeht.

Wird eine voll geschlossene Raumeinheit bei einem Schalt- und/oder Steuerschrank, der mindestens ein Unterschrankteil verwendet, gewünscht, dann ist vorgesehen, daß die Öffnung im Bereich des Unterschrankteiles mittels einer Bodenplatte mit abgebogenen Rändern verschließbar ist.

Eine weitere Erhöhung der Aufbaumöglichkeiten eines Schalt- und/oder Steuerschrankes mit den Schrankbauteilen des Bausatzes nach der Erfindung ergibt sich nach einer Weiterbildung dadurch, daß die Befestigungsränder von Unterschrankteil, Abdeckteil, Mittelschrankteil und Oberschrankteil mit Befestigungsbohrungen in einer einheitlichen Verteilung und Anordnung versehen ist, die die Verbindung benachbarter Schrankbauteile auch in zwei um eine vertikale Achse um 180° verdrehten Stellungen zulassen.

Aus einem Unterschrankteil und einem Abdeckteil läßt sich ein geschlossener Schalt- und/oder Steuerschrank dadurch bilden, daß die die Öffnung im Deckel eines Unterschrankteiles umschließenden Befestigungsränder mit den Befestigungsrändern eines Abdeckteiles verbunden sind.

Aus einem Mittelschrankteil und einem Abdeckteil ergibt sich ein Tisch-Bedienungspult mit einem Aufnahmeraum für elektrische Bauelemente, Baugruppen und dgl. dadurch daß die die Öffnung im Deckel des Anschlußteiles eines Mittelschrankteiles eines Abdeckteiles umschließenden Befestigungsränder mit den Befestigungsrändern verbunden sind.

Ein Steuerschrank mit Bedienungsfeld, Tableau oder dgl. wird nach einer weiteren Ausgestaltung dadurch erhalten, daß die die Öffnung im Deckel eines Unterschrankteiles umschließenden Befestigungsränder mit den die Öffnung im Boden eines Oberschrankteiles umschließenden Befestigungsränder verbunden sind. Dabei können die Türen des Unterschrankteiles und die Klappe, die Tür des Oberschrankteiles auf derselben Seite oder auf entgegengesetzten Seiten des Schrankes angeordnet sein.

Ein Tisch-Bedienungspult mit aufgesetztem Tableau oder dgl. erhält man nach einer weiteren Ausgestaltung dadurch, daß die die Öffnung im Deckel des Anschlußteiles des Mittelschrankteiles umschließenden Befestigungsränder mit den die Öffnung im Boden eines Oberschrankteiles umschließenden Befestigungsrändern verbunden sind.

Die Bauhöhe eines Schalt- und/oder Steuerschrankes läßt sich nach einer Ausgestaltung dadurch vergrößern, daß die die Öffnung im Deckel eines Unterschrankteiles umschließenden Befestigungsränder mit den die Öffnung eines zweiten um eine vertikale Achse um 180° verdreht aufgesetzten Unterschrankteiles umschließenden Befestigungsrändern verbunden sind und daß die die Öffnung im Boden des zweiten Unterschrankteiles umschließenden Befestigungsränder mit den Befestigungsrändern eines Abdeckteiles verbunden sind. Die um 180° verdrehte Stellung des zweiten Unterschrankteiles bringt im Verbindungsbereich dann einen kleinen Abstand der Türen der übereinandergesetzten Unterschrankteile.

Ein nach Art eines Tisches aufstellbares Tischpult erhält man nach einer Ausgestaltung dadurch, daß die die Öffnung im Deckel eines Unterschrankteiles umschließenden Befestigungsränder mit den die Öffnung im Boden des Anschlußteiles eines Mittelschrankteiles umschließenden Befestigungsrändern verbunden sind und daß die die Öffnung im Deckel des Anschlußteiles des Mittelschrankteiles umschließenden Befestigungsränder mit den Befestigungsrändern eines Abdeckteiles verbunden sind.

Dieses aufstellbare Tischpult kann mit einem zusätzlichen aufgesetzten Tableau, Bedienungspult oder dgl. versehen werden, wenn die Verbindung so vorgenommen wird, daß die die Öffnung im Deckel eines Unterschrankteiles umschließenden Befestigungsränder mit den die Öffnung im Boden des Anschlußteiles eines Mittelschrankteiles umschließenden Befestigungsrändern verbunden sind und daß die die Öffnung im Deckel des Anschlußteiles des Mittelschrankteiles umschließenden Befestigungsränder mit den die Öffnung im Boden eines Oberschrankteiles umschließenden Befestigungsrändern verbunden sind.

Anstelle des aufgesetzten Tableaus, Bedienungspultes oder dgl. kann der Schrankraum eines derartigen aufstellbaren Tischpultes dadurch noch wesentlich vergrößert werden, daß die die Öffnung im Deckel eines Unterschrankteiles umschließenden Befestigungsränder mit den die Öffnung im Boden des Anschlußteiles eines Mittelschrankteiles umschließenden Befestigungsrändern verbunden sind und daß die die Öffnung im Deckel des Anschlußteiles des Mittelschrankteiles umschließenden Befestigungsränder mit den die Öffnung im Boden eines zweiten Unterschrankteiles umschließenden Befestigungsrändern verbunden sind.

Die Erfindung wird anhand von verschiedenen, in den Zeichnungen dargestellten Ausführungsbeispielen näher erläutert. Es zeigt :

Figur 1 im Schnitt ein Unterschrankteil des Bausatzes nach der Erfindung,

Figur 2 im Schnitt ein Abdeckteil des Bausatzes nach der Erfindung,

Figur 3 im Schnitt ein Mittelschrankteil des Bausatzes nach der Erfindung,

Figur 4 im Schnitt ein Oberschrankteil des Bausatzes nach der Erfindung,

Figur 5 schematisch einen Schaltschrank aus einem Unterschrankteil und einem Abdeckteil,

Figur 6 schematisch ein Tisch-Bedienungspult aus einem Mittelschrankteil und einem Abdeckteil,

Figur 7 schematisch einen Schaltschrank mit aufgesetztem Tableau, Bedienungsfeld oder dgl. aus einem Unterschrankteil und einem Oberschrankteil,

Figur 8 schematisch den Schaltschrank nach Fig. 7, wobei das Unterschrankteil und das Oberschrankteil in 180° verdrehten Stellungen miteinander verbunden sind,

Figur 9 schematisch ein Tisch-Bedienungspult mit aufgesetztem Tableau, Bedienungsfeld oder dgl. aus einem Mittelschrankteil und einem Oberschrankteil,

Figur 10 schematisch einen in der Bauhöhe vergrößerten Schalt- und/oder Steuerschrank aus zwei Unterschrankteilen und einem Abdeckteil,

Figur 11 schematisch ein aufstellbares Tischpult aus einem Unterschrankteil, einem Mittelschrankteil und einem Abdeckteil,

Figur 12 schematisch das aufstellbare Tischpult nach Fig. 11, das anstelle des Abdeckteiles durch ein aufgesetztes Oberschrankteil erweitert ist und

Figur 13 schematisch das aufstellbare Tischpult nach Fig. 11, bei dem zwischen Mittelschrankteil und Abdeckteil ein weiteres Unterschrankteil eingefügt ist.

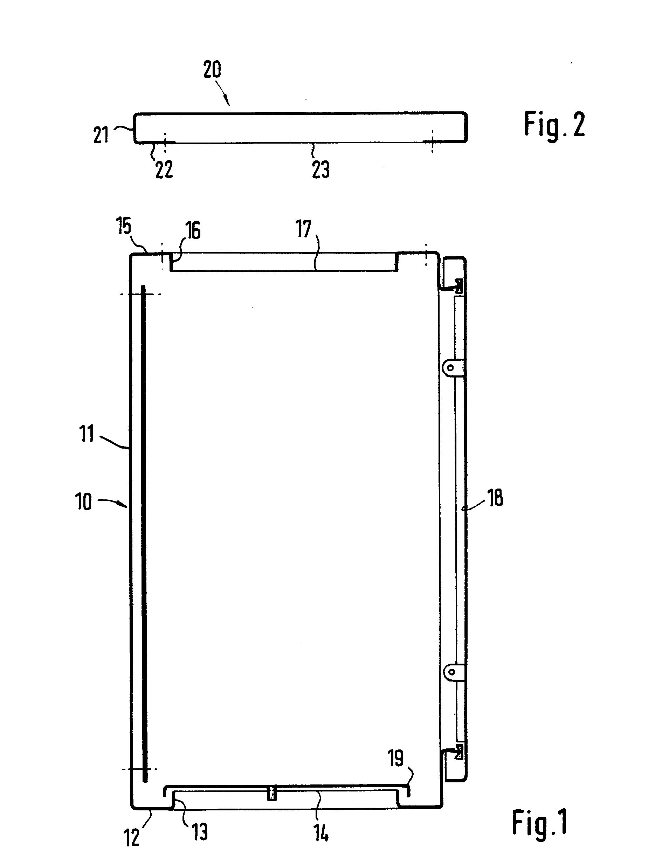

Das Unterschrankteil 10 nach Fig. 1 hat quadratischen oder rechteckförmigen Querschnitt. Die offene Frontseite wird mittels einer oder mehrerer Türen 18 verschlossen. Der Aufbau der Seitenwände des Unterschrankteiles 10 kann beliebig erfolgen. Wesentlich für die Erfindung ist, daß sowohl im Boden, als auch im Deckel des Unterschrankteiles 10 je eine Öffnung 14 bzw. 17 eingebracht ist. Diese Öffnungen 14 und 17 sind entsprechend quadratisch oder rechteckförmig und erstrecken sich vorzugsweise über den größten Bereich des Bodens und des Deckels, so daß nur schmale horizontale Befestigungsränder 12 und 15 übrig bleiben. Diese horizontalen Befestigungsränder 12 und 15 gehen unmittelbar in die vertikalen Seitenwände 11 des Unterschrankteiles 10 über. Die freien Kanten der Befestigungsränder 12 und 15 sind als Abschlußränder 13 und 16 zum Innenraum des Unterschrankteiles 10 hin eingebogen. Die Öffnung 14 im Boden kann mittels einer Bodenplatte 19 abgedeckt werden, die mit ihrem abgewinkelten Rand den Abschlußrand 13 der Befestigungsränder 12 übergreift.

Das Abdeckteil 20 nach Fig. 2 ist im wesentlichen eine Platte, die an ihren vier Seiten über die zur Unterseite hin abgebogenen Übergangsabschnitte 21 in die parallel zur Platte eingebogenen, horizontalen Befestigungsränder 22 übergeht. Diese Befestigungsränder 22 schließen ebenfalls eine Öffnung 23 ein, die in der Größe den Öffnungen 14 und 17 im Unterschrankteil 10 entspricht.

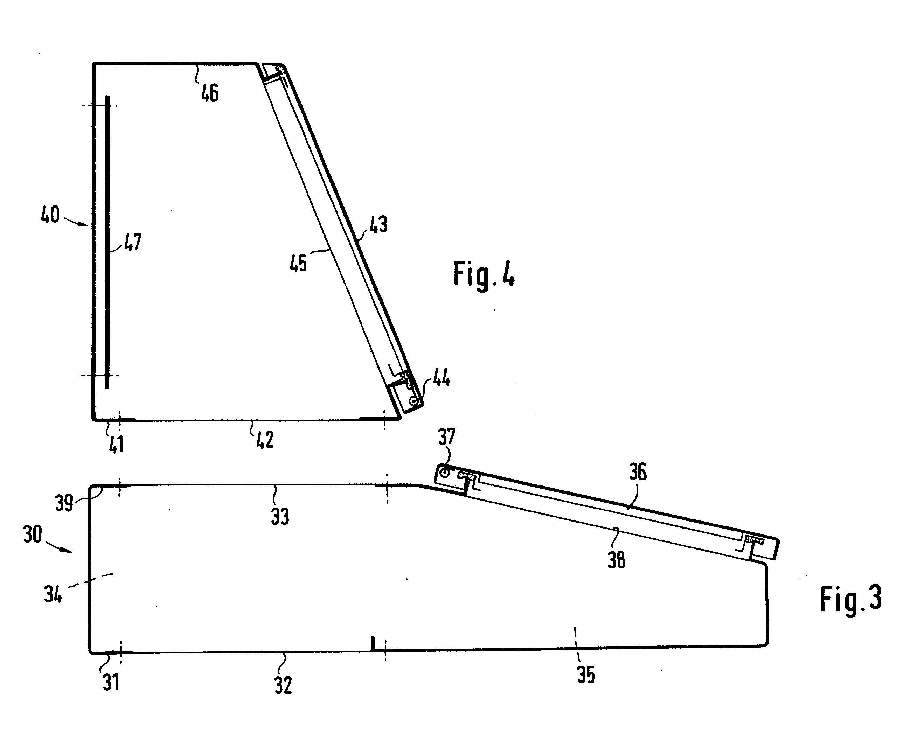

Das Mittelschrankteil 30 nach Fig. 3 umfaßt ein kastenförmiges Anschlußteil 34 und ein Pultteil 35, das sich an die Frontseite des Anschlußteiles 34 anschließt. Das Anschlußteil 34 des Mittelschrankteiles 30 hat im Boden und im Deckel die Öffnungen 32 und 33, die von den horizontalen Befestigungsrändern 31 und 39 umschlossen werden. Die Auslegung entspricht den Öffnungen 14 und 17 mit den Befestigungsrändern 12 und 15 des Unterschrankteiles 10, so daß das Pultteil 35 über ein mit dem Mittelschrankteil 30 verbundenes Unterschrankteil 10 vorsteht. Damit der Innenraum des Pultteiles 35 mit in die Raumeinheit des Anschlußteiles 34 einbezogen wird, gehen die Befestigungsränder 31 des Bodens direkt in den Boden des Pultteiles 35 und die Befestigungsränder 39 des Deckels direkt in die nach vorne geneigte, offene Oberseite des Pultteiles 35 über. Die Öffnung 38 in der Oberseite des Pultteiles 35 wird mittels einer Klappe 36 oder dgl. verschlossen, die mit der Schwenkachse 37 im Bereich der Oberkante der Öffnung 38 an dem Pultteil 35 des Mittelschrankteiles 30 angelenkt ist. Die Klappe 36 kann als Bedienungsplatte, als Tableau oder dgl. ausgebildet sein.

Das Oberschrankteil 40 nach Fig. 4 hat im Bodenbereich wieder die Abmessungen des Unterschrankteiles 10 bzw. des Anschlußteiles 34 des Mittelschrankteiles 30. Die Öffnung 42 ist gleich groß wie die Öffnungen 14 und 17 des Unterschrankteiles 10 und die Öffnungen 32 und 33 des Mittelschrankteiles 30 und wird von den horizontalen Befestigungsrändern 42 eingeschlossen. Der Deckel 46 des Oberschrankteiles 40 ist verschlossen und die offene, nach hinten geneigte Frontseite läßt sich mittels einer Klappe 43 oder dgl. verschließen. Dabei ist die Schwenkachse 44 vorzugsweise an der Unterkante der Öffnung 45 in der Frontseite angeordnet. In dem Oberschrankteil 40 kann im Bereich der Rückwand eine Montageplatte 47 angeordnet sein, ähnlich wie in dem Unterschrankteil 10.

Die horizontalen Befestigungsränder 41 gehen direkt in die vertikalen Seitenwände und die geneigte Frontseite des Oberschrankteiles 40 über. Die Klappe 43 kann wieder als Bedienungsfeld, als Tableau oder dgl. ausgebildet sein.

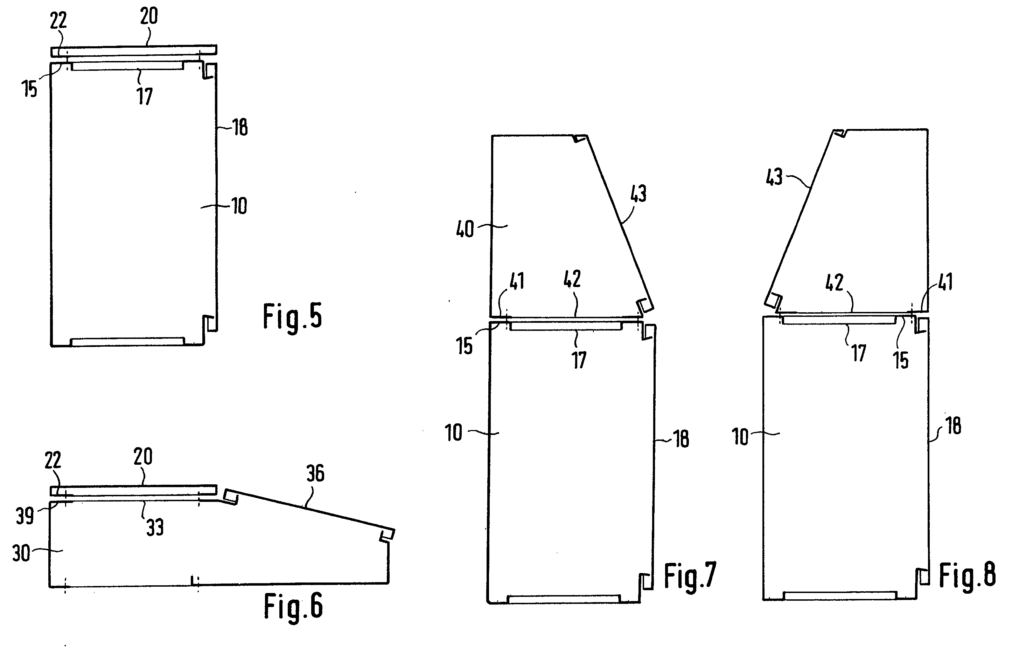

Wie das Ausführungsbeispiel nach Fig. 5 zeigt, kann das Unterschrankteil 10 mit einem Abdeckteil 20 zu einem Schalt- und/oder Steuerschrank vervollständigt werden. Die Öffnung 17 im Deckel des Unterschrankteiles 10 wird mittels des Abdeckteiles 20 verschlossen. Dabei werden die Befestigungsränder 15 des Unterschrankteiles 10 mit den Befestigungsrändern 22 des Abdeckteiles 20 verbunden. Es ist bei der Auslegung von Unterschrankteil 10, Abdeckteil 20, Mittelschrankteil 30 und Oberschrankteil 40 nur zu beachten, daß die Bohrungen in den Befestigungsrändern 12, 15, 22, 31, 39 und 41 in der Verteilung und Anordnung einheitlich sind und zwar so, daß die Schrankbauteile auch in zwei um 180° verdrehten Stellungen miteinander verbindbar sind, um noch weitere Aufbaumöglichkeiten zu erhalten, wie noch gezeigt wird.

Die Fig. 6 zeigt einen Schalt- und/oder Steuerschrank, der als Bedienungspult auf einem Tisch oder dgl. abgestellt werden kann. Das Mittelschrankteil 30 wird mit einem Abdeckteil 20 verbunden, das die Öffnung 33 im Deckel des Anschlußteiles 34 des Mittelschrankteiles 30 verschließt. Dabei werden die Befestigungsränder 39 des Mittelschrankteiles 30 mit den Befestigungsrändern 22 des Abdeckteiles 20 verbunden. Die Klappe 36 kann als Bedienungsfeld, Tableau oder dgl. ausgelegt sein.

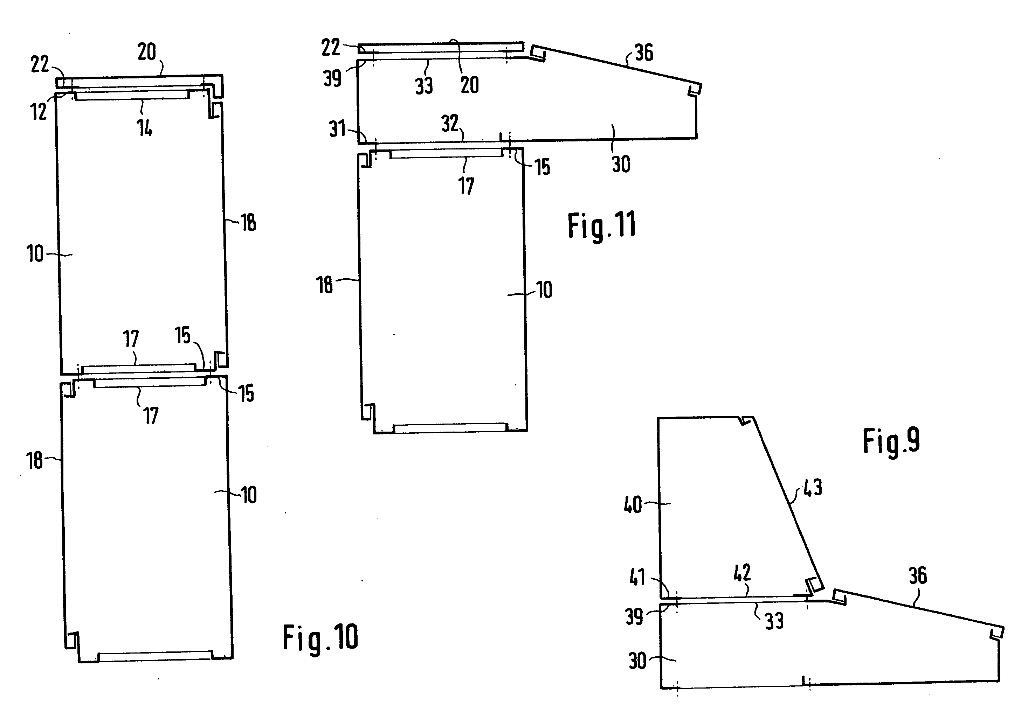

Das Ausführungsbeispiel nach Fig. 7 und 8 zeigt einen Schalt- und/oder Steuerschrank mit einem aufgesetzten Steuerpult oder dgl., der aus einem Unterschrankteil 10 und einem Oberschrankteil 40 zusammengesetzt wird. Dabei werden die Befestigungsränder 15 um die Öffnung 17 im Deckel des Unterschrankteiles 10 mit den Befestigungsrändern 41 um die Öffnung 42 im Boden des Oberschrankteiles 40 verbunden. Wie die Fig. 7 zeigt, können das Unterschrankteil 10 und das Oberschrankteil 40 so miteinander verbunden werden, daß die Türen 18 des Unterschrankteiles 10 und die Klappe 43 des Oberschrankteiles 40 auf derselben Seite des Schalt- und/oder Steuerschrankes liegen. Wie die Fig. 8 zeigt, kann das Unterschrankteil 10 und das Oberschrankteil 40 auch so miteinander verbunden werden, daß die Türen 18 des Unterschrankteiles 10 und die Klappe 43 des Oberschrankteiles 40 auf einander gegenüberliegenden Seiten des Schalt- und/oder Steuerschrankes angeordnet sind. Die Klappe 43 kann als Bedienungsfeld, Tableau oder dgl. ausgebildet sein.

Bei dem Ausführungsbeispiel nach Fig. 9 ist das auf einem Tisch abstellbare Bedienungspult nach Fig. 6 mit einem Oberschrankteil 40 erweitert, das anstelle des Abdeckteiles 20 im Bereich der Öffnung 33 mit den Befestigungsrändern 39 des Mittelschrankteils 30 verbunden ist und zwar mittels der die Öffnung 42 im Boden des Oberschrankteiles 40 umschließenden Befestigungsränder 41. Die zur Deckung gebrachten Öffnungen 33 und 42 verbinden die Innenräume von Mittelschrankteil 30 und Oberschrankteil 40 zu einer Raumeinheit. Die Klappen 36 und 43 können beliebig gestaltet sein, so z. B. als Bedienungsfeld, als Tableau oder dgl. Außerdem besteht auch die Möglichkeit, das Oberschrankteil 40 um 180° verdreht mit dem Mittelschrankteil 30 zu verbinden.

Anhand des Ausführungsbeispiels nach Fig. 10 wird gezeigt, wie ein in der Bauhöhe vergrößerter Schalt- und/oder Steuerschrank aus zwei Unterschrankteilen 10 und einem Abdeckteil 20 aufgebaut werden kann. Das zweite Unterschrankteil 10 wird horizontal um 180° gedreht auf das erste Unterschrankteil 10 aufgesetzt, so daß die die Öffnungen 17 in den Deckeln umschließenden Befestigungsränder 15 beider Unterschrankteile 10 miteinander verbunden werden können. Diese Art der Verbindung hat den Vorteil, daß der Abstand der Türen 18 im Verbindungsbereich klein bleibt. Die Türen 18 müssen ja von der Unterkante, d. h. dem Boden, des Unterschrankteiles 10 einen größeren Abstand haben, da sie sonst bei der Verbindung mit einem Mittelschrankteil 30 an dem Pultteil 35 anstoßen würden.

Dieser Spalt zwischen den Türen 18 der beiden aufeinander gesetzten Unterschrankteile 10 tritt nur dann in Erscheinung, wenn die Unterschrankteile 10 nach Fig. 10 in vertikal um 180° verdrehten Stellungen miteinander verbunden sind. Das Abdeckblech 20 wird mit seinen Befestigungsrändern 22 an den Befestigungsrändern 12 um die Öffnung 14 im Boden des zweiten Unterschrankteiles 10 angebracht.

Das Ausführungsbeispiel nach Fig. 11 zeigt ein nach Art eines Tisches aufstellbares Tischpult als Schalt- und/oder Steuerschrank. Die Befestigungsränder 15 um die Öffnung 17 im Deckel des Unterschrankteiles 10 werden mit den Befestigungrändern 31 um die Öffnung 32 im Boden eines Mittelschrankteiles 30 verbunden. Das Abdeckteil 20 wird mit seinen Befestigungsrändern 22 an den Befestigungsrändern 39 um die Öffnung 33 im Deckel des Mittelschrankteiles 30 angebracht. Die Klappe 36 kann als Bedienungsfeld, Tableau oder dgl. ausgebildet sein.

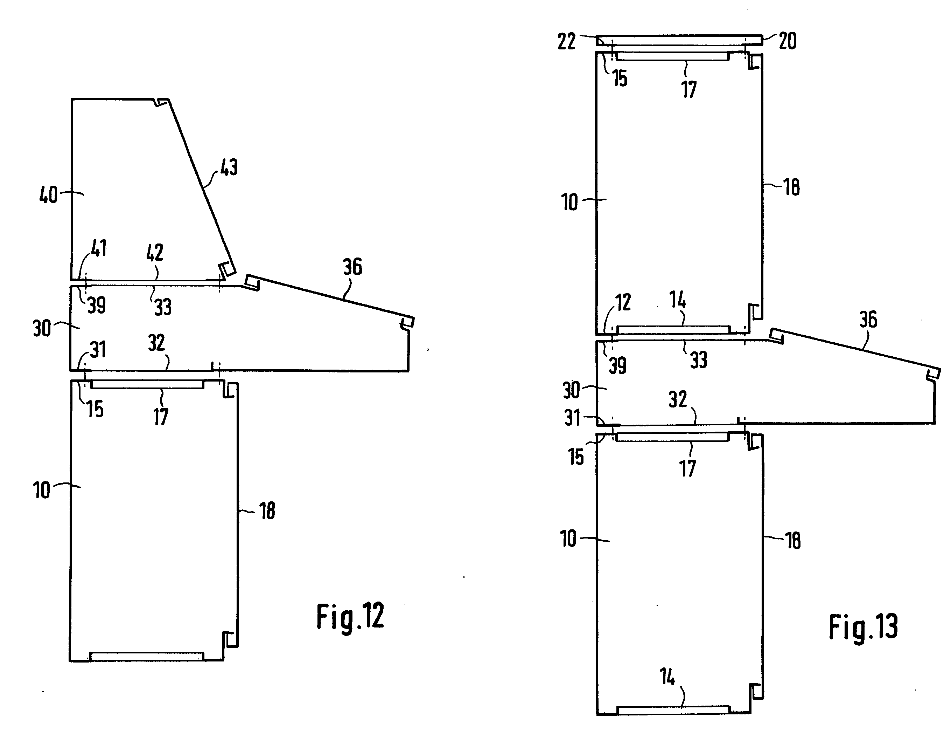

Reicht die Raumeinheit zur Unterbringung der elektrischen Bauelemente, Bauteile und dgl. nicht aus, dann kann das Tischpult nach Fig. 11 mit einem Oberschrankteil 40 oder einem Unterschrankteil 10 erweitert werden, wie die Ausführungsbeispiele nach Fig. 12 und 13 zeigen. Bei dem Ausführungsbeispiel nach Fig. 12 werden die Befestigungsränder 15 um die Öffnung 17 im Deckel des Unterschrankteiles 10 mit den Befestigungsrändern 31 um die Öffnung 32 im Boden des Mittelschrankteiles 30 sowie die Befestigungsränder 39 um die Öffnung 33 im Deckel des Mittelschrankteiles 30 mit den Befestigungsrändern 41 um die Öffnung 42 im Boden des Oberschrankteiles 40 verbunden. Bei dem Ausführungsbeispiel nach Fig. 13 ist die Verbindung zwischen dem ersten Unterschrankteil 10 und dem Mittelschrankteil 30 gleich. Das zweite, auf das Mittelschrankteil 30 aufgesetzte Oberschrankteil 40 wird jedoch über die Befestigungsränder 12 um die Öffnung 14 im Boden des zweiten Unterschrankteiles 10 mit den Befestigungsrändern 39 um die Öffnung 33 im Deckel des Mittelschrankteiles 30 mit dem Mittelschrankteil 30 verbunden. In beiden Ausführungsbeispielen können auch die Schrankbauteile vertikal um 180° verdreht mit ihren benachbarten Schrankbauteilen verbunden werden. Die Klappen 36 und 43 können beliebig gestaltet werden.

Es bleibt noch zu erwähnen, daß die Ausführungsbeispiele nach den Fig. 5 bis 13 nur eine Auswahl der Gestaltungsmöglichkeiten für einen Schalt- und/oder Steuerschrank darstellen, wie sie mit den Schrankbauteilen des Bausatzes nach der Erfindung gegeben sind. Es liegt im Rahmen der Erfindung, wenn der Fachmann aus den Schrankbauteilen des Bausatzes nach der Erfindung anders zusammengesetzte Schalt- und/oder Steuerschränke erstellt.

**Ansprüche**

1. Bausatz für Schalt- und/oder Steuerschränke zur Aufnahme von elektrischen Bauelementen und Baugruppen, bestehend aus folgenden Schrankbauteilen mit horizontale Befestigungsränder aufweisenden Öffnungen :

a) einem Unterschrankteil (10), dessen offene Frontseite mittels einer oder mehreren Türen (18) verschließbar ist und dessen Boden und Deckel gleich große, von horizontalen Befestigungsrändern (12, 15) umschlossene Öffnungen (14, 17) aufweisen,

b) einem Mittelschrankteil (30), das aus einem kastenartigen Anschlußteil (34) und einem an dessen Frontseite anschließendem Pultteil (35) gebildet ist, wobei das Anschlußteil (34) im Querschnitt dem Querschnitt des Unterschrankteiles (10) entspricht und im Boden und im Deckel Befestigungsränder (31, 39) und Öffnungen (32, 33) wie das Unterschrankteil (10) aufweist und wobei eine offene, nach vorne geneigte Oberseite des Pultteils (35) mittels einer Klappe (36) oder einer Tür verschließbar ist,

c) einem Oberschrankteil (40), das im Bodenbereich dem Querschnitt des Unterschrankteiles (10) entspricht und im Boden Befestigungsränder (41) und eine Öffnung (42) wie das Unterschrankteil (10) aufweist und dessen nach hinten geneigte, offene Frontseite mittels einer Klappe (43) oder einer Tür verschließbar ist und

d) einem Abdeckteil (20), das im Querschnitt dem Querschnitt des Unterschrankteiles (10) entspricht und zur Unterseite hin in horizontale Befestigungsränder (22) abgewinkelt ist, die eine Öffnung (23) wie im Unterschrankteil (10) umschließen.

2. Bausatz nach Anspruch 1, dadurch gekennzeichnet, daß die horizontalen Befestigungsränder (12, 15) des Unterschrankteiles (10) im Bereich der Öffnungen (14, 17) in vertikale Abschlußränder (13, 16) übergehen, welche zum Innenraum des Unterschrankteiles (10) hin abgebogen sind.

3. Bausatz nach Anspruch 1 oder 2, dadurch gekennzeichnet, daß die Öffnungen (14, 17) quadratisch oder rechteckförmig ausgebildet sind und daß die Befestigungsränder (12, 15) unmittelbar in die vier vertikalen Seitenwände des Unterschrankteiles (10) übergehen und gleiche Breite aufweisen.

4. Bausatz nach Anspruch 1, dadurch gekennzeichnet, daß die horizontalen Befestigungsränder (31, 39) im Boden und Deckel des Anschlußteiles (34) des Mittelschrankteiles (30) an der Frontseite unmittelbar in den Boden und die Oberseite des Pultteiles (35) übergehen.

5. Bausatz nach Anspruch 4, dadurch gekennzeichnet, daß die Klappe (36) oder die Tür im Bereich der Oberkante der offenen, nach vorne geneigten Oberseite des Mittelschrankteiles (30) angelenkt ist.

6. Bausatz nach Anspruch 4 oder 5, dadurch gekennzeichnet, daß die übrigen horizontalen Befestigungsränder (31, 39) im Bereich der Öffnungen (32, 33) unmittelbar in die vertikalen Seitenwände des kastenförmigen Anschlußteiles (34) des Mittelschrankteiles (30) übergehen und gleiche Breite aufweisen.

7. Bausatz nach Anspruch 1, dadurch gekennzeichnet, daß die horizontalen Befestigungsränder (41) im Boden des Oberschrankteiles (40) in die vertikalen Seitenwände und die nach hinten geneigte, offene Frontseite des Oberschrankteiles (40) übergehen und gleiche Breite aufweisen.

8. Bausatz nach Anspruch 7, dadurch gekennzeichnet, daß die Klappe (43) oder die Tür im Bereich der Unterkante der offenen, nach hinten geneigten Frontseite des Oberschrankteiles (40) angelenkt ist.

9. Bausatz nach Anspruch 1, dadurch gekennzeichnet, daß das Abdeckteil (20) plattenförmig ausgebildet ist und mittels eines umlaufenden, vertikal abgebogenen Übergangsabschnittes (21) in die horizontalen Befestigungsränder (22) übergeht.

10. Bausatz nach einem der Ansprüche 1 bis 9, dadurch gekennzeichnet, daß die Öffnung (14) im Bereich des Unterschrankteiles (10) mittels einer Bodenplatte (19) mit abgebogenen Rändern verschließbar ist.

11. Bausatz nach einem der Ansprüche 1 bis 10, dadurch gekennzeichnet, daß die Befestigungsränder (12, 15, 22, 31, 39, 41) von Unterschrankteil (10), Abdeckteil (20), Mittelschrankteil (30) und Oberschrankteil (40) mit Befestigungsbohrungen in einer einheitlichen Verteilung und Anordnung versehen sind, die die Verbindung benachbarter Schrankbauteile auch in zwei um eine vertikale Achse von 180° verdrehten Stellungen zulassen.

12. Schalt- und/oder Steuerschrank mit Schrankbauteilen des Bausatzes nach einem der Ansprüche 1 bis 11, dadurch gekennzeichnet, daß die die Öffnung (17) im Deckel eines Unterschrankteiles (10) umschließenden Befestigungsränder (15) mit den Befestigungsrändern (22) eines Abdeckteiles (20) verbunden sind (Fig. 5).

13. Schalt- und/oder Steuerschrank mit Schrankbauteilen des Bausatzes nach einem der Ansprüche 1 bis 11, dadurch gekennzeichnet, daß die die Öffnung (33) im Deckel des Anschlußteiles (34) eines Mittelschrankteiles (30) umschließenden Befestigungsränder (39) mit den Befestigungsrändern (22) eines Abdeckteiles (20) verbunden sind (Fig. 6).

14. Schalt- und/oder Steuerschrank mit Schrankbauteilen des Bausatzes nach einem der Ansprüche 1 bis 11, dadurch gekennzeichnet, daß die die Öffnung (17) im Deckel eines Unterschrankteiles (10) umschließenden Befestigungsränder (15) mit den die Öffnung (42) im Boden eines Oberschrankteiles (40) umschließenden Befestigungsränder (41) verbunden sind (Fig. 7 und 8).

15. Schalt- und/oder Steuerschrank mit Schrankbauteilen des Bausatzes nach einem der Ansprüche 1 bis 11, dadurch gekennzeichnet, daß die die Öffnung (33) im Deckel des Anschlußteiles (34) des Mittelschrankteiles (30) umschließenden Befestigungsränder (39) mit den die Öffnung (42) im Boden eines Oberschrankteiles (40) umschließenden Befestigungsrändern (41) verbunden sind (Fig. 9).

16. Schalt- und/oder Steuerschrank mit Schrankbauteilen des Bausatzes nach einem der Ansprüche 1 bis 11, dadurch gekennzeichnet, daß die die Öffnung (17) im Deckel eines Unterschrankteiles (10) umschließenden Befestigungsränder (15) mit den die Öffnung (17) eines zweiten, um eine vertikale Achse um 180° verdreht aufgesetzten Unterschrankteiles (10) umschließenden Befestigungsrändern (15) verbunden sind und daß die die Öffnung (14) im Boden des zweiten Unterschrankteiles (10) umschließenden Befestigungsränder (12) mit den Befestigungsrändern (22) eines Abdeckteiles (20) verbunden sind (Fig. 10).

17. Schalt- und/oder Steuerschrank mit Schrankbauteilen des Bausatzes nach einem der Ansprüche 1 bis 11, dadurch gekennzeichnet, daß die die Öffnung (17) im Deckel eines Unterschrankteiles (10) umschließenden Befestigungsränder (15) mit den die Öffnung (32) im Boden des Anschlußteiles (34) eines Mittelschrankteiles (30) umschließenden Befestigungsrändern (31) verbunden sind und daß die die Öffnung (33) im Deckel des Anschlußteiles (34) des Mittelschrankteiles (30) umschließenden Befestigungsränder (39) mit den Befestigungsrändern (22) eines Abdeckteiles (20) verbunden sind (Fig. 11).

18. Schalt- und/oder Steuerschrank mit Schrankbauteilen des Bausatzes nach einem der Ansprüche 1 bis 11, dadurch gekennzeichnet, daß die die Öffnung (17) im Deckel eines Unterschrankteiles (10) umschließenden Befestigungsränder (15) mit den die Öffnung (32) im Boden des Anschlußteiles (34) eines Mittelschrankteiles (30) umschließenden Befestigungsrändern (31) verbunden sind und daß die die Öffnung (33) im Deckel des Anschlußteiles (34) des Mittelschrankteiles (30) umschließenden Befestigungsränder (39) mit den die Öffnung (42) im Boden eines Oberschrankteiles (40) umschließenden Befestigungsrändern (41) verbunden sind (Fig. 12).

19. Schalt- und/oder Steuerschrank mit Schrankbauteilen des Bausatzes nach einem der Ansprüche 1 bis 11, dadurch gekennzeichnet, daß die die Öffnung (17) im Deckel eines Unterschrankteiles (10) umschließenden Befestigungsränder (15) mit den die Öffnung (32) im Boden des Anschlußteiles (34) eines Mittelschrankteiles (30) umschließenden Befestigungsrändern (31) verbunden sind und daß die die Öffnung (33) im Deckel des Anschlußteiles (34) des Mittelschrankteiles (30) umschließenden Befestigungsränder (39) mit den die Öffnung (14) im Boden eines zweiten Unterschrankteiles (10) umschließenden Befestigungsrändern (12) verbunden sind (Fig. 13).

## Claims

1. Construction kit for switchgear cabinets and/or control cabinets, for housing electrical components, sub-assemblies and modules, and consisting of the following cabinet sections with openings, the borders of which constitute horizontal mounting ledges :

a) one base cabinet section (10), the open front of which can be closed off by one or more doors (18), and the top and bottom panels of which have openings of the same size (14, 17), the borders of which constitute continuous horizontal mounting ledges (12, 15),

b) one middle cabinet section (30), consisting of a box-type connecting part (34) and a desk-shaped part (35) at the front of the latter, the connecting part (34) having a horizontal cross-section which matches the horizontal cross-section of the base cabinet section (10) and mounting ledges (31, 39) and openings (32, 33) in the top and bottom panels the same als the base cabinet section, and with the open top of the desk-shaped part (35) inclined down towards the front and capable of being closed off by a flap (36) or by a door,

c) one top cabinet section (40), having a horizontal cross-section at the bottom which matches the horizontal cross-section of the base cabinet section (10) and mounting ledges (41) and an opening (42) in the bottom panel, as in the base cabinet section (10) and the open front of which is inclined backwards and capable of being closed off by a flap (43) or by a door,

d) one cover panel section (20), the horizontal cross-section of which matches the horizontal cross-section of the base cabinet section (10), and which is bent over on the underside to form horizontal mounting ledges (22) which constitute the borders of an opening (23), as in the base cabinet section (10).

2. Construction kit as in Claim 1, but characterised by the fact that, the horizontal mounting ledges (12, 15) of the base cabinet section (10) around the openings (14, 17) are bent over into the interior of the base cabinet unit (10), so forming vertical rims (13, 16).

3. Construction kit as in Claim 1 or 2, but characterised by the fact that, the openings (14, 17) are square or rectangular and the mounting ledges (12, 15) merge directly into the four vertical side walls of the base cabinet section (10) and are of the same breadth.

4. Construction kit as in Claim 1, but characterised by the fact that, the horizontal mounting ledges (31, 39) in the top and bottom panels of the connecting part (34) of the middle cabinet section (30) merge directly into the top and bottom panels of the desk-shaped part (35).

5. Construction kit as in Claim 4, but characterised by the fact that, the flap (36) or door is hinged in the region of the top edge of the open top which is inclined down towards the front of the middle cabinet section (30).

6. Construction kit as in Claim 4 or 5, but characterised by the fact that, the remaining horizontal mounting ledges (31, 39) around the openings (32, 33) merge directly into the side walls of the box-type connecting part (34) of the middle cabinet section (30) and are of the same breadth.

7. Construction kit as in Claim 1, but characterised by the fact that, the horizontal mounting ledges (41) in the floor panel of the top cabinet section (40) merge directly into the vertical side walls and the open front, which is inclined backwards, of the top cabinet section (40) and are of the same breadth.

8. Construction kit as in Claim 7, but characterised by the fact that, the flap (43) or door in hinged in the region of the bottom edge of the open front, which is inclined backwards, of the cabinet top section (40).

9. Construction kit as in Claim 1, but characterised by the fact that, the cover panel section (20) is a flat plate, with an intermediate section (21) bent vertically downwards all around it, and which then merges into the horizontal mounting ledges (22).

10. Construction kit as in Claims 1 to 9, but characterised by the fact that, the opening (14) in the base cabinet section (10) is capable of being closed off by a floor plate (19) the edges of which are bent downwards.

11. Construction kit as in Claims 1 to 10, but characterised by the fact that, the mounting ledges (12, 15, 22, 31, 39 and 41) of the base cabinet section (10), cover panel section (20), middle cabinet section (30) and the top cabinet section (40) are provided with holes drilled in the same uniform spacing and layout, which enable two contiguous cabinet sections to be joined together even if rotated vertically through 180°.

12. Switchgear cabinet and/or control cabinet with parts from the construction kits as in Claims 1 to 11, but characterised by the fact that, the mounting ledges (15) surrounding the opening (17) in the top panel of a base cabinet section (10) are joined to the mounting ledges (22) of a cover panel section (20) (Fig. 5).

13. Switchgear cabinet and/or control cabinet with parts from the construction kits as in Claims 1 to 11, but characterised by the fact that, the mounting ledges (39) surrounding the opening (33) in the top panel of the connecting part (34) of a middle cabinet section (34) are joined to the mounting ledges (22) of a top cover panel (20) (Fig. 6).

14. Switchgear cabinet and/or control cabinet with parts from the construction kits as in Claims 1 to 11, but characterised by the fact that, the mounting ledges (15) surrounding the opening (17) in the top panel of a base cabinet section (10) are joined to the mounting ledges (41) surrounding the opening (42) in the bottom panel of a top cabinet section (40) (Figs. 7 and 8).

15. Switchgear cabinet and/or control cabinet with parts from the construction kits as in Claims 1 to 11, but characterised by the fact that, the mounting ledges (39) surrounding the opening (33) in the top panel of the middle cabinet section (30) are joined to the mounting ledges (41) surrounding the opening (42) in the bottom panel of a top section (40) (Fig. 9).

16. Switchgear cabinet and/or control cabinet with parts from the construction kits as in Claims 1 to 11, but characterised by the fact that, the mounting ledges (15) surrounding the opening (17) in the top panel of a base cabinet section (10) are joined to the mounting ledges (15) surrounding the opening (17) of a second base cabinet section (10) which has been turned vertically through 180°, and the mounting ledges (12) surrounding the opening (14) in the bottom panel of the second base cabinet section (10) are joined to the mounting ledges (22) of a cover panel section (20) (Fig. 10).

17. Switchgear cabinet and/or control cabinet with parts from the construction kits as in Claims 1 to 11, but characterised by the fact that, the mounting ledges (15) surrounding the opening (17) in the top panel of a base cabinet section (10) are joined to the mounting ledges (31) surrounding the opening (32) in the bottom panel of the connecting part (34) of a middle cabinet section (30), and the mounting ledges (39) surrounding the opening (33) in the top panel of the connecting part (34) of the middle cabinet section (30) are joined to the mounting ledges (22) of a panel section (Fig. 11).

18. Switchgear cabinet and/or control cabinet with parts from the construction kits as in Claims 1 to 11, but characterised by the fact that, the mounting ledges (15) surrounding the opening (17) in the top panel of a base cabinet section (10) are joined to the mounting ledges (31) surrounding the opening (32) in the bottom panel of the connecting part (34) of a middle cabinet section (30), and the mounting ledges (39) surrounding the opening (33) in the top panel of the connecting part (34) of the middle cabinet section (30) are joined to the mounting ledges (41) surrounding the opening (42) in the bottom panel of a top cabinet section (40) (Fig. 12).

19. Switchgear cabinet and/or control cabinet with parts from the construction kits as in Claims 1 to 11, but characterised by the fact that, the mounting ledges (15) surrounding the opening (17) in the top panel of a base cabinet section (10) are joined to the mounting ledges (31) surrounding the opening (32) in the bottom panel of the connecting part (34) of a middle cabinet section (30), and the mounting ledges (39) surrounding the opening (33) in the top panel of the connecting part (34) of the middle cabinet section (30) are joined to mounting ledges (12) surrounding the opening (14) in the bottom panel of a second base cabinet section (10) (Fig. 13).

## Revendications

1. Ensemble de construction pour armoires de manœuvre et/ou de commande pour l'installation d'unités et d'ensembles électriques, comprenant les composants d'armoire avec ouvertures dans les bords de fixation horizontaux suivants :

a) une partie inférieure de l'armoire (10) dont la partie frontale ouverte peut être verrouillée à l'aide d'une ou plusieurs portes (18) et dont le fond et le couvercle présentent des ouvertures (14, 17) de même dimension entourées par des bords de fixation horizontaux (12, 15),

b) un panneau d'armoire centrale (30), composé d'une partie intermédiaire en forme de boîte (34) et d'un élément de pupitre fixé sur la partie frontale de celui-ci (35), de façon à ce que la partie intermédiaire (34) corresponde dans sa section transversale à la section transversale de la partie inférieure de l'armoire (10) et présente dans le fond et sur le couvercle des bords de fixation (31, 39) et des ouvertures (32, 33) identiques à ceux de la partie inférieure de l'armoire (10). Une partie supérieure ouverte et inclinée vers l'avant du pupitre (35) peut être verrouillée à l'aide d'un clapet (36) ou d'une porte,

c) une partie supérieure de l'armoire (40), qui correspond dans la partie du fond à la section transversale de la partie inférieure de l'armoire (10) et qui présente dans le fond des bords de fixation (41) et une ouverture (42) identiques à ceux la partie inférieure de l'armoire (10) et dont la partie frontale ouverte et inclinée vers l'arrière peut être verrouillée à l'aide d'un clapet (43) ou d'une porte, et

d) un couvercle (20) qui correspond dans sa section transversale à la section transversale de la partie inférieure de l'armoire (10) et qui est coudé vers la partie inférieure dans des bords de fixation horizontaux (22), qui entourent une ouverture (23) identique à celle de la partie inférieure de l'armoire (10).

2. Ensemble de construction d'après la revendication 1, caractérisé par le fait que les bords de fixation horizontaux (12, 15) de la partie inférieure de l'armoire (10) entrent dans les bordures verticales (13, 16) dans la zone des ouvertures (14, 17) ces bordures étant coudées vers l'intérieur de la partie inférieure de l'armoire (10).

3. Ensemble de construction selon la revendication 1 ou 2, caractérisé par le fait que les ouvertures (14, 17) soient carrées ou rectangulaires et que les bords de fixation (14, 17) entrent directement dans les quatre panneaux latéraux verticaux de la partie inférieure de l'armoire (10) et qu'ils présentent la même largeur.

4. Ensemble de construction selon la revendication 1, caractérisé par le fait que les bords de fixation horizontaux (31, 39) dans le fond et dans le couvercle de la partie intermédiaire (34) du panneau d'armoire centrale (30) dans la partie frontale entrent directement dans le fond et la partie supérieure de l'élément de pupitre (35).

5. Ensemble de construction selon la revendication 4, caractérisé par le fait que le clapet (36) ou la porte dans la zone du bord supérieur de la partie supérieure ouverte et inclinée vers l'avant du panneau d'armoire centrale (30) soient articulés.

6. Ensemble de construction selon la revendication 4 ou 5, caractérisé par le fait que les autres bords de fixation horizontaux (31, 39) dans la zone des ouvertures (32, 33) entrent directement dans les panneaux verticaux latéraux de la partie intermédiaire en forme de boîte (34) du panneau d'armoire centrale (30) et qu'ils présentent la même largeur.

7. Ensemble de construction selon la revendication 1, caractérisé par le fait que les bords de fixation horizontaux (41) entrent dans le fond de la partie supérieure de l'armoire (40) dans les panneaux latéraux verticaux et dans la partie frontale ouverte et inclinée vers l'arrière de la partie supérieure de l'armoire (40) et qu'ils présentent la même largeur.

8. Ensemble de construction selon la revendication 7, caractérisé par le fait que le clapet (43) ou la porte dans la zone du bord inférieur de la partie frontale ouverte et inclinée vers l'arrière de la partie supérieure de l'armoire (40) soient articulés.

9. Ensemble de construction selon la revendication 1, caractérisé par le fait que le couvercle (20) soit en forme de plaque et entre à l'aide d'une section intermédiaire circulaire (21), articulée verticalement dans les bords de fixation horizontaux (22).

10. Ensemble de construction selon l'une des revendications de 1 à 9, caractérisé par le fait que l'ouverture (14) dans la zone de la partie inférieure de l'armoire (10) puisse être verrouillée à l'aide d'un panneau de fond (19) avec des bords courbés.

11. Ensemble de construction selon l'une des revendications de 1 à 10, caractérisé par le fait que des trous de fixation soient prévus dans les bords de fixation (12, 15, 22, 31, 39, 41) de la partie inférieure de l'armoire (10), le couvercle (20), la partie supérieure (40) et la partie centrale (30) de l'armoire dans une répartition unitaire et à distance égale, trous de fixation permettant la communication entre les composants avoisinants de l'armoire, se trouvant en deux positions différentes, c'est-à-dire déplacés de 180° autour de l'axe vertical.

12. Armoire de manœuvre et/ou de commande avec composants de l'ensemble de construction de l'armoire selon l'une des revendications de 1 à 11 caractérisée par le fait que les bords de fixation (15) entourant l'ouverture (17) dans le couvercle d'une partie inférieure de l'armoire (10) soient reliés aux bords de fixation (22) d'un couvercle (20) (Fig. 5).

13. Armoire de manœuvre et/ou de commande avec composants de l'ensemble de construction de l'armoire selon l'une des revendications de 1 à 11, caractérisée par le fait que les bords de fixation (39) entourant l'ouverture (33) dans le couvercle de la partie intermédiaire (34) d'un panneau d'armoire centrale (30) soient reliés aux bords de fixation (22) d'un couvercle (20) (Fig. 6).

14. Armoire de manœuvre et/ou de commande avec composants de l'ensemble de construction de l'armoire selon l'une des revendications de 1 à 11, caractérisée par le fait que les bords de fixation (15) entourant l'ouverture (17) dans le couvercle de la partie inférieure de l'armoire (10) soient reliés aux bords de fixation (41) entourant l'ouverture (42) dans le fond de la partie supérieure de l'armoire (40) (Fig. 7 et 8).

15. Armoire de manœuvre et/ou de commande avec composants de l'ensemble de construction de l'armoire selon l'une des revendications de 1 à 11, caractérisée par le fait que les bords de fixation (39) entourant l'ouverture (33) dans le couvercle de la partie intermédiaire (34) du panneau d'armoire centrale (30) soient reliés aux bords de fixation (41) entourant l'ouverture (42) dans le fond de la partie supérieure de l'armoire (40) (Fig. 9).

16. Armoire de manœuvre et/ou de commande avec composants de l'ensemble de construction de l'armoire selon l'une des revendications de 1 à 11, caractérisée par le fait que les bords de fixation (15) entourant l'ouverture (17) dans le couvercle de la partie inférieure de l'armoire (10) soient reliés aux bords de fixation (15) entourant l'ouverture (17) d'une partie inférieure d'une deuxième armoire déplacée de 180° autour de l'axe vertical, et que les bords de fixation (12) entourant l'ouverture (14) dans le fond de la partie inférieure de la deuxième armoire (10) soient reliés aux bords de fixation (22) d'un couvercle (20) (Fig. 10).

17. Armoire de manœuvre et/ou de commande avec composants de l'ensemble de construction de l'armoire selon l'une des revendications de 1 à 11, caractérisée par le fait que les bords de fixation (15) entourant l'ouverture (17) dans le couvercle de la partie inférieure de l'armoire (10) soient reliés aux bords de fixation (31) entourant l'ouverture (32) dans le fond d'une partie intermédiaire (34) d'un panneau d'armoire centrale (30) et que les bords de fixation (39) entourant l'ouverture (33) dans le couvercle d'une partie intermédiaire (34) du panneau d'armoire centrale (30) soient reliés aux bords de fixation (22) d'un couvercle (20) (Fig. 11).

18. Armoire de manœuvre et/ou de commande avec composants de l'ensemble de construction de l'armoire selon l'une des revendications de 1 à 11, caractérisée par le fait que les bords de fixation (15) entourant l'ouverture (17) dans le couvercle d'une partie inférieure de l'armoire (10) soient reliés aux bords de fixation (31) entourant l'ouverture (32) dans le fond de la partie intermédiaire (34) d'un panneau d'armoire centrale (30) et que les bords de fixation (39) entourant l'ouverture (33) dans le couvercle de la partie intermédiaire (34) de l'armoire centrale soient reliés aux bords de fixation (41) entourant l'ouverture (42) dans le fond d'une partie supérieure de l'armoire (40) (Fig. 12).

19. Armoire de manœuvre et/ou de commande avec composants de l'ensemble de construction de l'armoire selon l'une des revendications de 1 à 11, caractérisée par le fait que les bords de fixation (15) entourant l'ouverture (17) dans le couvercle d'une partie inférieure de l'armoire (10) soient reliés aux bords de fixation (31) entourant l'ouverture (32) dans le fond de la partie intermédiaire (34) d'un panneau d'armoire centrale (30) et que les bords de fixation (39) entourant l'ouverture (33) dans le couvercle de la partie intermédiaire (34) du panneau d'armoire centrale (30) soient reliés aux bords de fixation (12) entourant l'ouverture (14) dans le fond d'une partie inférieure d'une deuxième armoire (10) (Fig. 13).

0 062 241

Fig. 2

Fig.1

1

Fig.4

Fig.3

0 062 241

0 062 241

Fig.8

41
18
42
15
17
43
10

Fig.7

43
18
42
41
17
40
15
10

Fig.5

18
20
10
17
22
15

Fig.6

36
20
33
39
30
22

3

Fig.11

Fig.10

Fig.9

0 062 241

Fig.12

Fig.13

0 062 241